# EUROPEAN PATENT SPECIFICATION

(11) **EP 4 152 905 B1**
(45) Date of publication and mention of the grant of the patent: **23.04.2025**
(21) Application number: 22306240.7
(22) Date of filing: 18.08.2022
(51) Int. Cl.: H05K 7/20

(54) **IMMERSION-COOLED ELECTRONIC DEVICE AND COOLING MONITORING SYSTEM FOR IMMERSION-COOLED ELECTRONIC DEVICE**
TAUCHGEKÜHLTE ELEKTRONISCHE VORRICHTUNG UND KÜHLUNGSÜBERWACHUNGSSYSTEM FÜR TAUCHGEKÜHLTE ELEKTRONISCHE VORRICHTUNG
DISPOSITIF ÉLECTRONIQUE REFROIDI PAR IMMERSION ET SYSTÈME DE SURVEILLANCE DE REFROIDISSEMENT POUR DISPOSITIF ÉLECTRONIQUE REFROIDI PAR IMMERSION

(43) Date of publication of application: 22.03.2023
(73) Proprietor: OVH, 59100 Roubaix (FR)
(72) Inventor: CHEHADE, Ali, 59283 Moncheaux (FR); HNAYNO, Mohamad, 59100 Roubaix (FR); KLABA, Henryk, 59100 Roubaix (FR)
(74) Representative: BCF Global

(56) References cited:
- EP-A1- 3 188 580
- US-A1- 2013 146 273
- US-A1- 2014 218 861

## Description

### FIELD OF TECHNOLOGY

The present technology relates to immersion-cooled electronic equipment. In particular, the present technology relates to detection of anomalies in cooling of an immersion-cooled electronic device.

### BACKGROUND

Electronic equipment, for example servers, memory banks, computer disks, and the like, is conventionally grouped in equipment racks. Large data centers and other large computing facilities may contain thousands of racks supporting thousands or even tens of thousands of servers. The racks, including equipment mounted in their backplanes, consume large amounts of electric power and generate significant amounts of heat. Cooling needs are important in such racks. Some electronic devices, such as processors, generate so much heat that they could fail within seconds in case of a lack of cooling.

Liquid cooling, in particular water cooling, has been used as an addition or replacement to traditional forced-air cooling. Cold plates, for example water blocks having internal channels for channelized water circulation, may be mounted on heat-generating components, such as processors, to displace heat from the processors toward heat exchangers. Immersion cooling (sometimes called immersive cooling) has also recently gained traction. Electronic components are inserted in a container that is fully or partially filled with a non-conducting cooling liquid, for example an oil-based dielectric cooling liquid. Efficient thermal contact is obtained between the electronic components and the dielectric cooling liquid. Immersion cooling systems commonly take the form of large tanks in which the electronic devices are submerged. Hybrid cooling systems involving both water cooling and immersion cooling have recently been introduced.

However, such cooling systems may not be efficient enough to remove enough thermal energy from the electronic device and/or may be prone to malfunctions (e.g. leakage of water within the dielectric cooling liquid). As such, a system for monitoring the cooling systems of an immersion-cooled electronic device may be desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

European Patent No. 3,188,580 discloses a system for cooling electronic equipment accommodating plural electronic devices in an open space of a cooling bath provided with an inlet port and an outlet port for a liquid coolant. The cooling system is configured to directly cool the electronic devices by immersion of the electrotonic device in the liquid coolant circulated in the open space.

U.S. Patent Application Publication No. 2013/0146273 discloses a sealable module adapted to be filled with a first cooling liquid and a heat transfer device having a conduction surface defining a channel for receiving a second cooling liquid. At least a portion of the conduction surface or housing is shaped in conformity with the shape of the electronic component.

U.S. Patent Application Publication No. 2014/0218861 discloses an immersion server including a first surface that is exposed when the server is submerged within a cooling liquid, and at least one vapor bubble deflector physically abutting the first surface and extending away from the first surface at an angle. The deflector divides the first surface into an upper segment and a lower segment. When the server is submerged, the cooling liquid surrounding the lower segment absorbs sufficient heat to evaporate and generate vapor bubbles rising to the liquid surface. The vapor bubble deflector deflects the rising vapor bubbles away from the surface of the upper segment.

### SUMMARY

Embodiments of the present technology have been developed based on developers' appreciation of shortcomings associated with the prior art. In particular, such shortcomings may include the difficulty of detecting leaks of a channelized liquid, such as is used in water blocks, into the dielectric cooling liquid in a cooling system that uses both water blocks (or other liquid-cooled cold plates), and by immersion cooling.

The object of the invention is solved by an electronic device according to claim 1. Preferred embodiments are presented in the dependent claims.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 shows a perspective view of a rack system for housing numerous rack-mounted assemblies;
Figure 2 shows another perspective view of the rack system of Figure 1;
Figure 3 is a block diagram of electric connections of electric components hosted by the rack system of Figure 1;
Figure 4 shows a perspective view of a rack-mounted assembly;
Figure 5 is a schematic diagram of cooling monitoring system implemented in the rack-mounted assembly of Figure 4;
Figure 6 shows the bottom portion of an immersion case including a leak detection arrangement that includes conductivity sensors, in accordance with various embodiments of the disclosure;
Figure 7 shows the bottom portion of an immersion case including a leak detection arrangement that includes a pH sensor, in accordance with various embodiments of the disclosure; and
Figure 8 is a block diagram of a controller of the cooling monitoring system of Figure 5.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represents conceptual views of illustrative systems embodying the principles of the present technology.

With these fundamentals in place, we will now consider some non-limiting examples to illustrate various implementations of aspects of the present disclosure.

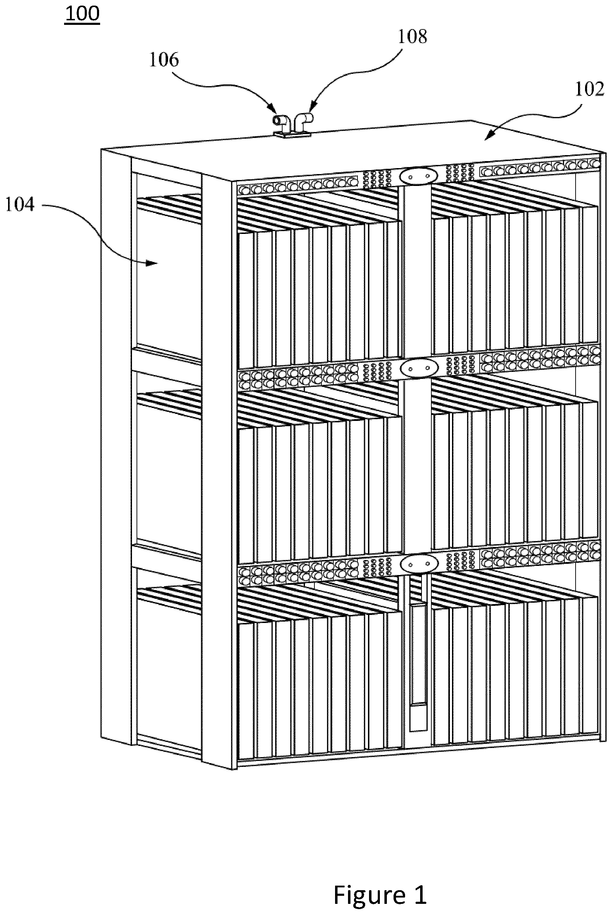

Figure 1 shows a perspective view of a rack system 100 for housing numerous rack-mounted assemblies 104. As shown, the rack system 100 may include a rack frame 102, rack-mounted assemblies 104, a liquid cooling inlet conduit 106 and a liquid cooling outlet conduit 108. As described more fully below, the rack-mounted assemblies 104 may be oriented vertically with respect to the rack frame 102, resembling books on a library shelf. This arrangement may provide for mounting a large number of such rack-mounted assemblies 104 in the rack frame 102, relative to conventional arrangements, particularly with respect to conventional arrangements of immersion-cooled rack-mounted assemblies.

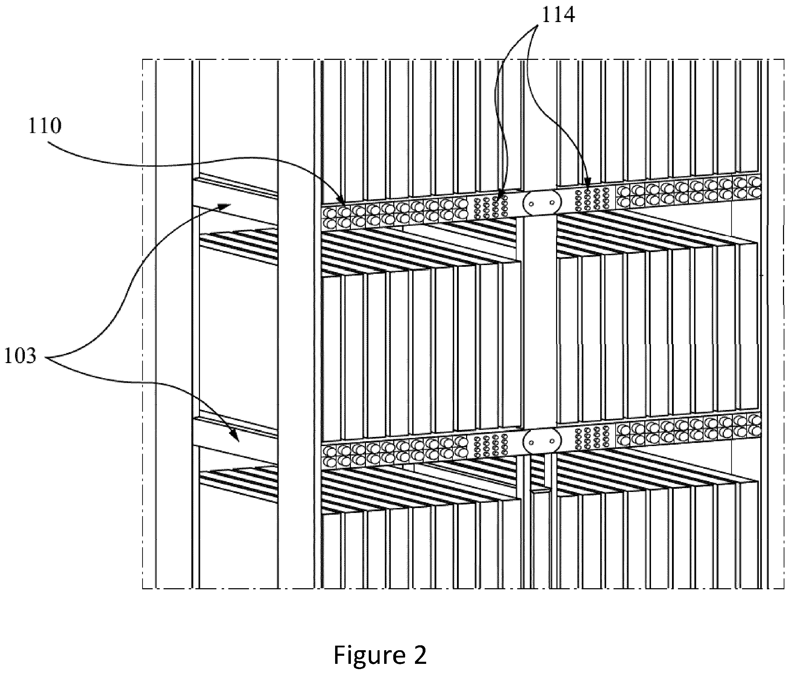

Figure 2 shows another perspective view of the rack system 100. As shown, the rack system 100 may further comprise a power distribution unit 110 and liquid coolant inlet/outlet connectors 114. It is to be noted that the rack system 100 may include other components such as heat exchangers, cables, pumps or the like, however, such components have been omitted from Figures 1 and 2 for clarity of understanding. As shown in Figures 1 and 2, the rack frame 102 may include shelves 103 to accommodate one or more rack-mounted assemblies 104. As noted above, the one or more rack-mounted assemblies 104 may be arranged vertically with respect to the shelves 103. In some embodiments, guide members (not shown) may be used on the shelves 103 to guide the rack-mounted assemblies 104 into position during racking and de-racking, and to provide proper spacing between the rack-mounted assemblies 104 for racking and de-racking.

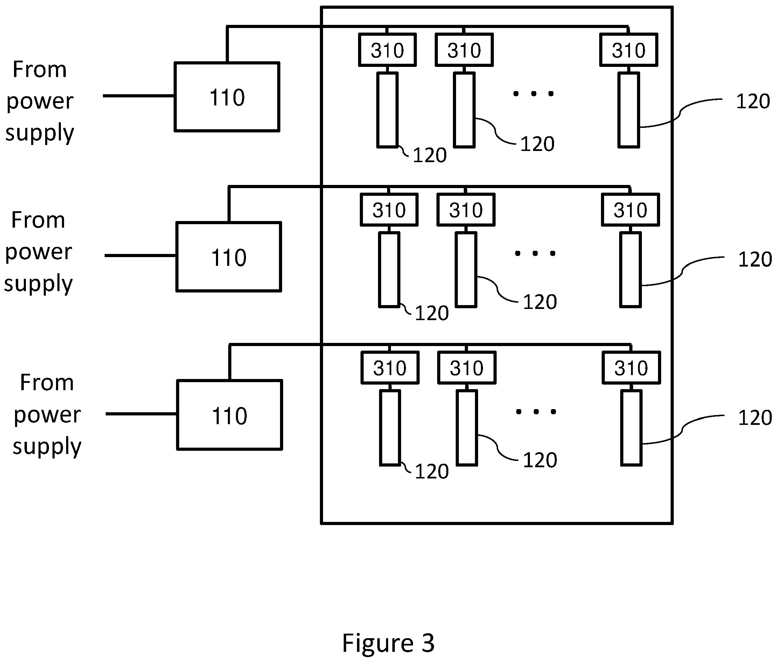

Figure 3 is a schematic diagram of electronic connections of the electronic devices 120 (e.g. servers) hosted in the rack system 100. In this embodiment, each electronic device 120 is electrically connected to a power distribution unit (PDU) 110 in parallel with one or more other electronic devices 120. A plurality of PDUs 110 may be used to distribute electric power to all of the electronic devices 120 hosted in the rack system 100. In this illustrative example of Figure 3, three PDUs 110 receive electric power from a same or different power supplies and distribute electric power to a plurality of corresponding electronic devices 120.

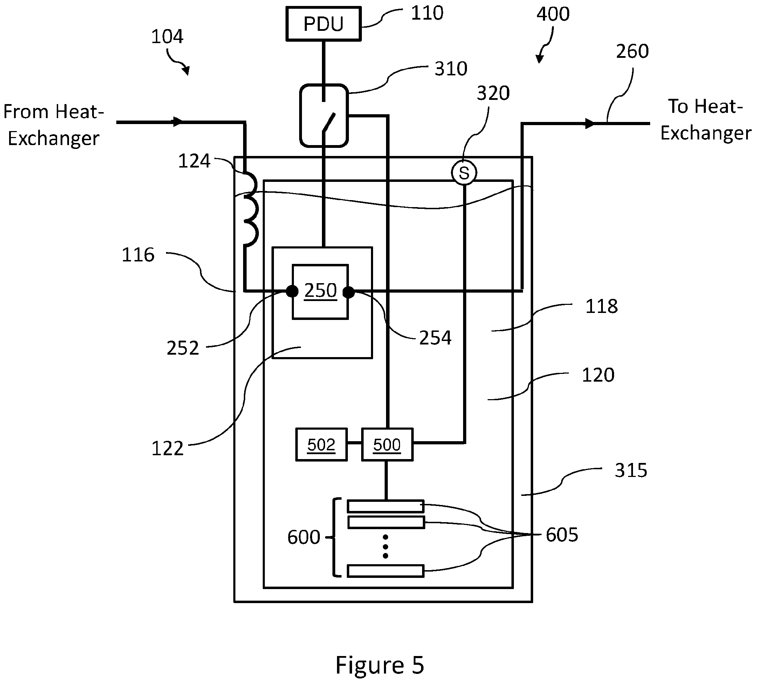

In this embodiment, each electronic device 120 is electrically connected to a corresponding PDU 110 over a switching device 310 (e.g. a Solid State Relay). The switching device 310 is selectively closed or open to respectively disconnect and connect the electronic device 120 to the PDU 110. Operation of the switching device 310 is performed by a controller 500 (see Figure 5) and is described in greater details herein after.

Each PDU 110 includes an input connector for receiving electric power from a power supply (e.g. AC power supply). The power supply may be a monophasic power supply or a multi-phasic power supply. The input connector may be, for example and without limitation, a CEE 7-type plug for use in European countries. Each PDU 110 further includes a plurality of output connectors for electrically connecting a plurality of corresponding electronic devices 120 via the switching devices 310. The output connectors may be, for example and without limitations, C13-type plugs. In some embodiments, each PDU 110 includes eight (8) output connectors.

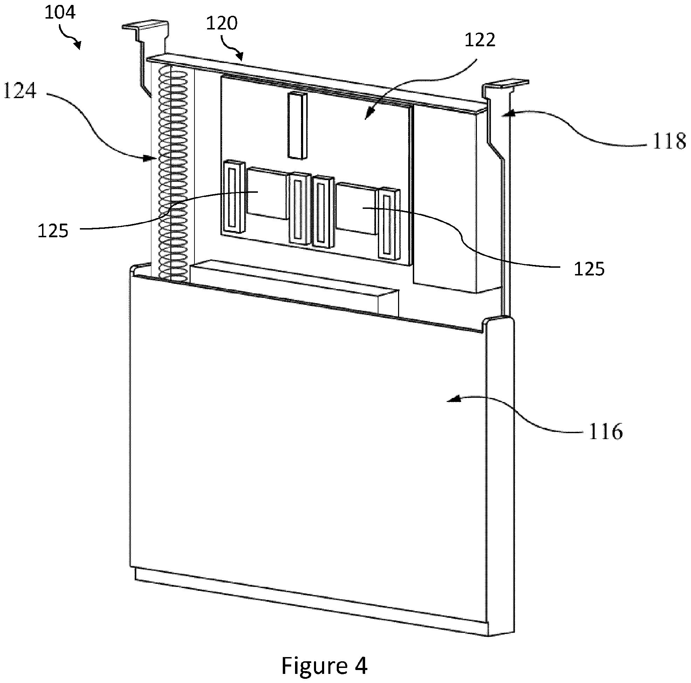

Figure 4 shows a perspective view of the rack-mounted assembly 104. As shown, the rack-mounted assembly 104 includes a detachable frame, or "board" 118 of the electronic device 120, and an immersion case 116. The board 118 holds electronic components 122 of the electronic device 120 and may be immersed in the immersion case 116. Although the immersion case 116, board 118, and electronic components 122 are show as separate parts, it will be understood by one of ordinary skill in the art that, in some embodiments, two or more of these components could be combined. For example, the electronic components 122 could be fixed directly on the board 118 and/or the immersion case 116.

It is contemplated that the electronic devices 120 may generate a significant amount of heat. Consequently, the rack system 100 may use a cooling system to cool down the electronic devices 120 to prevent the electronic devices 120 from being damaged. In this embodiment, the cooling system is a hybrid cooling system including an immersion cooling system and a channelized cooling system.

As used herein, an immersion cooling system is a cooling system in which the electronic device is in direct contact with a non-conductive (dielectric) cooling liquid, which either flows over at least portions of the electronic device, or in which at least portions of the electronic device are submerged. For example, in the rack-mounted assembly 104, the immersion case 116 may contain a dielectric immersion cooling liquid (not shown in Figure 4). Further, the board 118 including the electronic components 122 may be submerged at least in part in the immersion cooling case 116. In some embodiments, the dielectric immersion cooling liquid and the board 118 may be inserted into the immersion case 116 via an opening 122 at the top of the immersion case 116. In some embodiments, the opening 122 may remain at least partially open during operation of the electronic device 120, providing a non-sealed configuration for the immersion case 116. Such non-sealed configurations may be easier to manufacture and maintain than sealed configurations, but may be inappropriate for, e.g., two-phase systems, in which the immersion cooling liquid may boil during operation of the electronic device 120.

In some embodiments, the immersion case 116 may also include structures or devices for cooling the dielectric cooling liquid. For example, a convection-inducing structure, such as a serpentine convection coil 124 in which a flow of cooling liquid (e.g. water) is maintained may be used to cool the dielectric cooling liquid via natural convection. Alternatively or additionally, a pump (not shown) may be used to circulate the dielectric cooling liquid either within the immersion case 116 or through an external cooling system (not shown). In some embodiments, a two-phase system in which dielectric cooling liquid in a gaseous phase is cooled by condensation may be used. Generally, any technology or combination for cooling the dielectric cooling liquid may be used without departing from the principles disclosed herein. The serpentine convection coil 124 may be omitted or replaced with other convection-inducing structures or devices for circulating the dielectric immersion cooling liquid in some embodiments.

As used herein, a channelized cooling system is a cooling system in which heat-generating components of the electronic device 120 (i.e. the electronic components 122) are cooled using one or more liquid cooling units 250, which may also be called "cold plates" or "water blocks" (although a liquid circulating through the "water blocks" may be any of a wide variety of known thermal transfer liquids, rather than water). Liquid connections of the liquid cooling units 250 are described in greater details herein after. Examples of heat-generating components that may be cooled using such a thermal transfer devices include, but are not limited to, central processing units (CPUs), graphics processing units (GPUs), neural processing units (NPUs), tensor processing units (TPUs), power supply circuitry, and application specific integrated circuits (ASICs), including, for example, ASICs configured for high-speed cryptocurrency mining. The present disclosure describes a cooling monitoring system that detect anomalies of the cooling of the electronic device 120 and that may disconnect the electronic device 120 from its corresponding power supply in reponse to detecting an anomaly.

Figure 5 is a schematic representation of a cooling monitoring system 400 implemented in the rack-mounted assembly 104 in accordance with some embodiments of the present technology. In the illustrative embodiment of Figure 5, the electronic device 120 is a server that may be implemented as a conventional computer server. In an example of an embodiment of the present technology, each electronic device 120 may be implemented as a Dell^{™} PowerEdge^{™} Server running the Microsoft^{™} Windows Server^{™} operating system. Needless to say, each electronic device 120 may be implemented in any other suitable hardware, software, and/or firmware, or a combination thereof.

The electronic device 120 includes one or more electronic components 122 (only one of which is illustrated for clarity of the Figure 5) and the board 118 on which the one or more electronic components 122 are mounted. The board 118 is at least in part immersed in the immersion case 116 that contains a volume of a heat-transfer liquid 315 for cooling of the electronic device 120. More specifically, the electronic device 120 is at least in part immersed in the heat-transfer liquid 315 for immersion cooling thereof. In this embodiment, the heat-transfer liquid 315 is a dielectric cooling liquid. As such, the electronic device 120 may be referred to as a "immersion-cooled electronic device".

Additionally, the electronic device 120 is also cooled by the channelized cooling system that circulates a channelized cooling liquid, or a "second heat-transfer liquid", through one or more liquid cooling units 250 (only one of which is illustrated for clarity of the Figure 5) such as "water blocks" on the electronic component 122 or some other heat-generating components of the electronic device. The liquid cooling unit 250 has an external thermal transfer surface configured to be in contact with the electronic component 122. It is to be understood that in this context, the external thermal transfer surface is said to be "in contact" with the electronic component 122 even in cases where a thermal paste is applied between the external thermal transfer surface and the electronic component 122, in a manner that is known in the art, to ensure adequate heat transfer between the electronic component 122 and the external thermal transfer surface of the liquid cooling unit 250. More specifically, in this embodiment, the liquid cooling unit 250 is thermally coupled to the electronic component 122 to be cooled, and the channelized cooling liquid is circulated through an internal liquid conduit (not shown) of the liquid cooling unit 250 to absorb the heat from the electronic device 120. As the heat-transfer liquid flows out of the liquid cooling unit 250, so does the thermal energy absorbed thereby.

The liquid cooling unit 250 may for example include a liquid inlet 252 fluidly connected to the liquid cooling inlet conduit 106 of the rack 100 (Figure 1) for receiving the second heat-transfer liquid. The second heat-transfer liquid may thus flow through the internal liquid conduit of the liquid cooling unit 250 that zigzags within the liquid cooling unit 250 to maximize the heat absorption potential of the heat-transfer liquid across a surface of the liquid cooling unit 250. The internal liquid conduit may terminate at a liquid outlet 254 for discharging hot second heat-transfer liquid to the liquid cooling outlet conduit 108 of the rack 100 (Figure 1). The second heat-transfer liquid is further directed in a channelized cooling loop 260 to be cooled in a heat exchanger (e.g. a dry cooler).

In this embodiment, the liquid cooling unit 250 is also submerged within the heat-transfer liquid 315. The serpentine convection coil 124 introduced in the description of Figure 4, if present, may be structured with multiple hollow-channel coils to provide a high surface area exposure relative to the heat-transfer liquid 315 while also maintaining compact overall length and width dimensions. With this structure, direct channelized liquid cooling within the serpentine convection coil 124 allows to cool the ambient temperature of the heat-transfer liquid 315 and to induce natural thermal convection in the heat-transfer liquid 315. That is, the serpentine convection coil 124 internally conveys the circulating channelized cooling liquid that operates to cool the heat-transfer liquid 315. The channelized cooling liquid may be a different liquid than the heat-transfer liquid 315. That is, the channelized cooling liquid may include water, alcohol, or any suitable liquid capable of sustaining adequate cooling temperatures. In some embodiments, the channelized cooling liquid comprisees water and glycol. As illustrated, the serpentine convection coil 124 is connected in series with the liquid cooling unit 250, the latter being in a downstream position. In one alternative, the liquid cooling unit 250 may be upstream of the serpentine convection coil 124. In another alternative, the channelized cooling liquid may flow in parallel within the liquid cooling unit 250 and the serpentine convection coil 124. In yet another alternative, the liquid cooling unit 250 and the serpentine convection coil 124 may be independent, being connected to different sources of cooling liquid. It will be understood that although the system shown in Figure 5 uses the serpentine convection coil 124 for cooling the heat-transfer liquid 315, other convection-inducing structures (not shown) or other cooling technologies (not shown), as discussed above, could be used instead of or in addition to the serpentine convection coil 124.

After absorbing heat from the electronic device 120 and from the heat-transfer liquid 315, the heated channelized cooling liquid is conveyed through a heat exchanger system (not shown), the operation of which will generally be familiar to those of skill in the art. The heat exchanger system cools the channelized cooling fluid, which may then be recirculated to the rack system 100 through a channelized cooling loop.

It will be understood that there may be many additional features, combinations, and variations of such hybrid cooling systems combining channelized liquid cooling and immersion cooling of the electronic device 120. In some embodiments, multiple electronic devices, similar to the electronic device 120, may be immersed in a single immersion case or an immersion tank.

Other variations may involve changing the order of the components and/or the serpentine convection coil in the channelized cooling loop. For example, the channelized cooling fluid may flow through the serpentine convection coil after flowing through the liquid cooling unit 250. In some embodiments, the serpentine convection coil may be part of a different channelized cooling loop than the liquid cooling units 250. These variations and additional features may be used in various combinations, and may be used in connection with the embodiments described above, or other embodiments.

The cooling monitoring system 400 includes the controller 500 and one or more sensors communicably connected to the controller 500. In an embodiment, the sensors transmit measurement signals for the operating parameter of the heat-transfer liquid 315 to the controller 500. The controller 500 further determines that the measurement signals indicate that the operating parameter of the heat-transfer liquid 315 is above the threshold by comparing measurement values carried in the measurement signals with the threshold.

In another embodiment, the sensors transmit a fault signal to the controller 500 in response to detecting that the operating parameter of the heat-transfer liquid 315 is above the threshold. The controller 500 further cause to disconnect the electronic device 120 from the power supply in response to receiving the fault signal. In this embodiment, the sensors may thus be refered to as "anomaly sensors".

Operating parameters that are measured by the sensors may be a temperature, a conductivity, a viscosity, a density, and/or any other physical or chemical characteristics of the heat-transfer liquid 315.

As shown in Figure 5, the controller 500 is mounted on the board 118 of the electronic device 120 and operably connected to the corresponding switching device 310 of the electronic device 120 such that, in use, the controller 500 may open or close the switching device 310. More specifically, the controller 500 causes to disconnect, in response to determining that the measurement signals received from the sensors indicate that the operating parameter of the heat-transfer liquid 315 is above a given threshold, the electronic device 120 (i.e. the electronic components 122) from the power supply. As such, the cooling monitoring system 400 may increase safety of the rack system 100 and, more generally, of the datacenter, by electrically and individually disconnecting servers or other electronic devices 120 from power supplies in response to detecting faulty cooling in corresponding rack-mounted assemblies 104.

In an embodiment, the switching device 310 may be integrated in the electronic device 120. In other embodiments, the switching device 310 may be located outside the electronic device 120 (e.g. along a power line that transmits electric power from the PDU 110 to the electronic device 120).

As has been discussed above, hybrid cooling systems for electronic devices120 may include both immersion cooling systems, in which the electronic devices are immersed or submerged in a dielectric immersion cooling liquid, and channelized cooling systems, in which heat transfer devices such as water blocks are used to cool components of the electronic device, using a liquid that flows through channels between and within the heat transfer devices.

In some cases, the same liquid may be used as both the dielectric immersion cooling liquid and the channelized cooling liquid (i.e., the liquid that flows through the water blocks). However, in some systems, the characteristics of the dielectric immersion cooling liquid and/or the cost of the dielectric immersion cooling liquid may render it inappropriate for use in the channelized cooling system. Often, the channelized cooling liquid will be water, or some other liquid that provides appropriate heat transfer characteristics for the channelized cooling system, but may not be usable for immersion cooling, *e.g.,* due to its conductivity or due to corrosion or other damage that it may cause to components of the electronic device. For example, if water is used as the channelized cooling liquid, it is likely that the concentration of ions in the water will cause the water to be sufficiently conductive to cause damage to electronic components. Even if the water is initially provided as distilled or deionized water, the concentration of ions will increase as the water is circulated through the channelized cooling system.

To avoid damage to immersed or submerged electronic devices, it is desirable to determine whether channelized cooling liquid is leaking into the dielectric immersion cooling liquid. Dielectric immersion cooling liquids are typically either hydrocarbon- or fluorocarbon-based and typically have densities that are lower than the density of water. If the channelized cooling liquid has a higher density than the dielectric immersion cooling liquid, which will typically be the case, then the channelized cooling fluid eventually leaking into the immersion cooling liquid will sink to a bottom portion of the immersion case.

In accordance with various embodiments of the disclosure, a leak detection arrangement, such as a sensor, may be installed in a bottom portion of the immersion case 116 of each rack-mounted assembly 104 (or in a bottom portion of any part of the rack system 100 where the dielectric cooling liquid may flow) to detect the presence of the channelized cooling liquid, which would indicate that there is a leak in the channelized cooling system. Generally, this bottom portion of the immersion case 116 should be far enough below any immersed or submerged electronic device 120 that, absent a major leak, the channelized cooling fluid will not collect around any components of the electronic device 120. Once the fluid is detected, an alarm may be raised, or an operator may otherwise be informed of the immersion case 116 in which the leak was detected so that remedial measures may be taken.

In an embodiment, the sensors include a leak detection arrangement 600 communicably connected to the controller 500 and adapted to determine a presence of the second heat-transfer liquid in a bottom portion of the immersion case 116. More specifically, the second heat-transfer liquid used for liquid cooling of the electronic device 120 is selected to have a density that is higher than a density of the heat-transfer liquid 315. As a result, in case of leakage of the second heat-transfer liquid within the immersion case 116, the second heat-transfer liquid sinks to the bottom of the immersion case 116. In this embodiment, in order to detect a presence of the second heat-transfer liquid in the immersion case 116, the leak detection arrangement 600 is disposed in a bottom portion of the board 118. Broadly speaking, the leak detection arrangement 600 may include any sensor adapted to measure a temperature, a conductivity, a viscosity, a density, and/or any other physical or chemical characteristics of the heat-transfer liquid 315.

In an embodiment, the leak detection arrangement 600 includes one or more conductivity sensors 605 for determining a conductivity of a fluid at the bottom portion of the board 118. In this embodiment, the second heat-transfer liquid is water. As a result, the conductivity sensors 605 are expected to determine a conductivity value that is non-null, or at least a variation of the measured conductivity value, in response to some of the second heat-transfer liquid having leaked to the bottom portion of the immersion case 116.

In an embodiment, the leak detection arrangement 600 transmits measurement signals including information about a measured conductivity of the heat-transfer liquid 315 to the controller 500. The controller 500 further determines that the measurement signals indicate that the conductivity of the heat-transfer liquid 315 is above the threshold by comparing measurement values carried in the measurement signals with the pre-determined conductivity threshold.

In another embodiment, the leak detection arrangement 600 transmits a fault signal to the controller 500 in response to determining that a real measured conductivity is above a predetermined conductivity threshold. In some embodiments, value of the pre-determined conductivity threshold is stored in a memory of the controller 500 and the leak detection arrangement 600 transmits data including information about the real measured conductivity. The controller 500 then compares the real measured conductivity to the pre-determined conductivity threshold. In response to the real measured conductivity being greater than the pre-determined conductivity threshold, the controller 500 may open the switching device 310.

In this embodiment, the leak detection arrangement 600 includes a plurality of conductivity sensors 605 disposed one above another along a gravity axis, each conductivity sensor 605 being communicably connected to the controller 500. In use, a fill rate of the second heat-transfer liquid in the immersive case 116 may be determined based on conductivity values measured by the conductivity sensors 605. More specifically, as the second heat-transfer liquid leaks from the channelized cooling loop 260, a bottommost conductivity sensor 605 may first transmit a fault signal to the controller 500. Later in time as the second heat-transfer liquid continues to leak from the channelized cooling loop 260 and fills the immersion case 116, a second conductivity sensor 605, adjacent and above the bottommost conductivity sensor 605 along the gravity axis, may further transmit a second fault signal to the controller 500 upon measuring a conductivity value above the pre-determined conductivity threshold. Altenatively, the

A fill rate and temporal evolution thereof may thus be determined based on times of reception of the different fault signals from the respective conductivity sensors 605. In some embodiments, the controller 500 further triggers, in response to determining the fill rate, a counter 502 indicative of an amount of time that has passed since the fill rate has been determined. In response to the counter 502 reaching a first pre-determined count value, the controller 500 may cause to disconnect the electronic device 120 from the power supply. More specifically, once the counter 502 reaches the first pre-determined count value, the controller 500 may open the switching device 310 to disconnect from the PDU 110 and from the power supply. In some embodiments, in response to the counter 502 reaching a second pre-determined count value, the controller 500 may transmit an alert signal to an operator device communicably connected thereto to indicate occurence of an anomaly to an operator of the datacenter. The second pre-determined count value may be smaller than the first pre-determined count value. There may be a higher number of pre-determined count values and associated alert signals in alternative embodiments.

In some embodiments, the pre-determined count value is based on the determined fill rate. For example, the pre-determined count value associated with fill rate determined to be between 0.1L per hour and 0.4L per hour may be 30 minutes. The pre-determined count value associated with fill rate determined to be between 0.4L per hour and 0.8L per hour may be 10 minutes. The controller 500 may thus disconnect the electronic device 120 from the power supply before the leaking channelized cooling liquid reaches sensitive components of the electronic device 120 (e.g. the electronic components 122).

In an embodiment, the cooling monitoring system 400 further includes a temperature sensor 320. The temperature sensor 320 measures a temperature of the heat-transfer liquid 315, a vapor thereof and/or air located at a top portion of the immersion case 116. The temperature sensor 320 may be located near a top of the heat-transfer liquid 315, as shown on Figure 5, or may be placed in any other suitable location. The temperature sensor 320 transmits a fault signal to the controller 500 in response to measuring a temperature above a pre-determined temperature threshold. As such, the controller 500 may open the switching device 310 to disconnect from the PDU 110 and from the power supply in response to the temperature at the top portion of the immersion case being greater than the pre-determined temperature threshold.

In some embodiment, the controller 500 may trigger a new parallel instance of the counter 502 upon receiving the fault signal from the temperature sensor 320. In response to the counter reaching a third pre-determined count value, the controller 500 may cause to disconnect the electronic device 120 from the power supply. More specifically, once the counter 502 reaches the third pre-determined count value, the controller 500 may open the switching device 310 to disconnect the electronic device 120 from the PDU 110 and from the power supply. In some embodiments, in response to the counter 502 reaching a fourth pre-determined count value, the controller 500 may transmit an alert signal to an operator device communicably connected thereto to indicate occurence of an anomaly to an operator of the datacenter. The fourth pre-determined count value may be smaller than the first pre-determined count value.

In a given rack system (e.g. the rack system 100), selective disconnection of the electronic devices 120 from the power supply by the corresponding controllers 500 facilitates operation of the electronic devices 120 in case an anomaly is detected. Indeed, if a faulty cooling system is detected by a corresponding cooling monitoring system 400, the corresponding electronic device 120 is disconnected from the power supply without impacting operation of the other electronic devices 120 in other rack-mounted assemblies 104 of the rack system 100. For example, propagation of potential damages of a short-circuit occurring in a given electronic device 120 (e.g. server) of the datacenter is limited by individual discsonnection of the servers from the power supply.

In some embodiments, the controller 500 is communicably connected with an operator interface (not shown) of the datacenter (e.g. a control room of the datacenter) and transmits, in response to determining occurence of an anomaly, a second fault signal to the operator including information about the faulty electronic device 120 in which the cooling monitoring system 400 has detected an anomaly (e.g. leaking channelized cooling liquid). Said information may include, without limitation, an identification of the faulty electronic device 120 and data provided by the sensors.

In some embodiments, the controller 500 is communicably connected with a valve (e.g. a solenoid valve) located in the channelized cooling loop 260 upstream the serpentine convection coil 124 and the liquid cooling unit 250, external to the immersion case 116. In response to determining occurence of an anomaly, the controller 500 also closes the valve in order to limit damages to the electronic device 120.

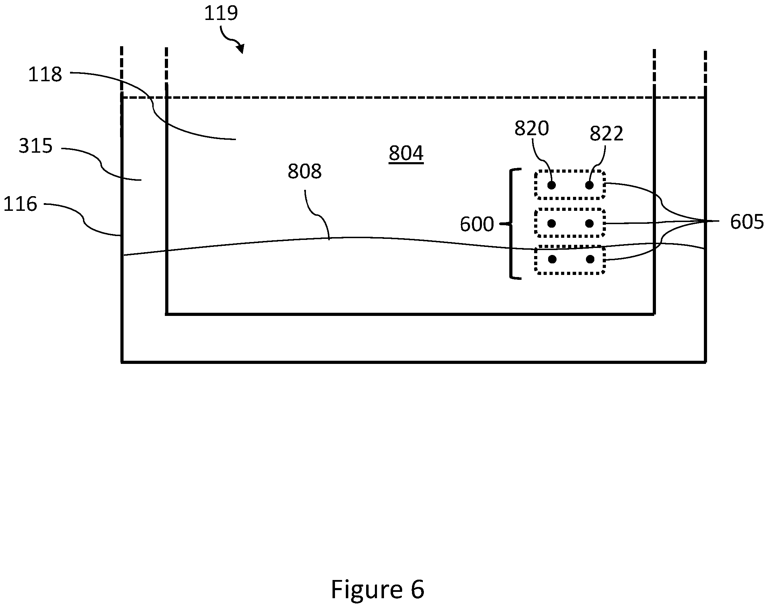

Figure 6 shows an embodiment, in which the varying electrical properties of the liquids are used to detect a leak of the channelized cooling liquid. A bottom portion 804 of the immersion case 116 of a hybrid cooling system that includes both the aforementioned immersion cooling and channelized liquid cooling is shown. In this embodiment, each conductivity sensor 605 of the leak detection arrangement 600 includes electrodes 820 and 822, which are used to measure the conductivity of the liquid between the electrodes 820 and 822. This may be done, *e.g.,* by imposing a constant voltage between the electrodes 820 and 822, and measuring changes in the current that occur as a result of the conductivity/resistivity of the liquid. It will be understood that other known methods for measuring conductivity/resistivity could also be used.

The dielectric immersion cooling liquid 315 has very low conductivity. Thus, when there has been no leak, there will be low conductivity (or high resistivity) between the electrodes 820 and 822. In the example shown in Figure 6, a leak has occurred in the channelized cooling system, so channelized cooling liquid 808 is collected at the bottom of the immersion case 116. The conductivity of the channelized cooling liquid 808 is much higher than the conductivity of the dielectric immersion cooling liquid 806. When the level of the channelized cooling liquid 808 reaches the bottommost conductivity sensor 605, this difference in conductivity is detected by the electrodes 820 and 822, indicating that a leak has occurred.

It will be understood by those of ordinary skill in the art that many variations on a system that uses conductivity or resistivity measurement to detect the presence of the channelized cooling liquid may be used. For example, the electrodes 820 and 822 may be disposed within a single unit or holder of a given conductivity sensor 605 that is open to liquid, and that holds the electrodes 820 and 822 at a predetermined distance from each other. In some embodiments, such a holder may be configured to be mounted in the immersion case 116 through a "standardized" opening in the bottom portion of the immersion case 116, which is configured to receive any of a variety of sensors or other leak detection arrangements for determining the presence of the channelized cooling liquid in the bottom portion of the immersion case 116.

In the illustrative embodiment of Figure 6, the bottommost conductivity sensor 605 is immersed in the leaked channelized cooling liquid 808. A first conductivity measurement signal, which may in this case be a fault signal, may thus be transmitted by the bottommost conductivity sensor 605 to the controller 500. In response to the level of the leaked channelized cooling liquid 808 reaching a consecutive conductivity sensor 605, a second conductivity measurement signal, which may in this case be another fault signal, may be transmitted by said consecutive conductivity sensor 605 to the controller 500. A difference between reception times of the first and second signals may be used by the controller 500 to further determined the fill rate of the leaked channelized cooling liquid 808.

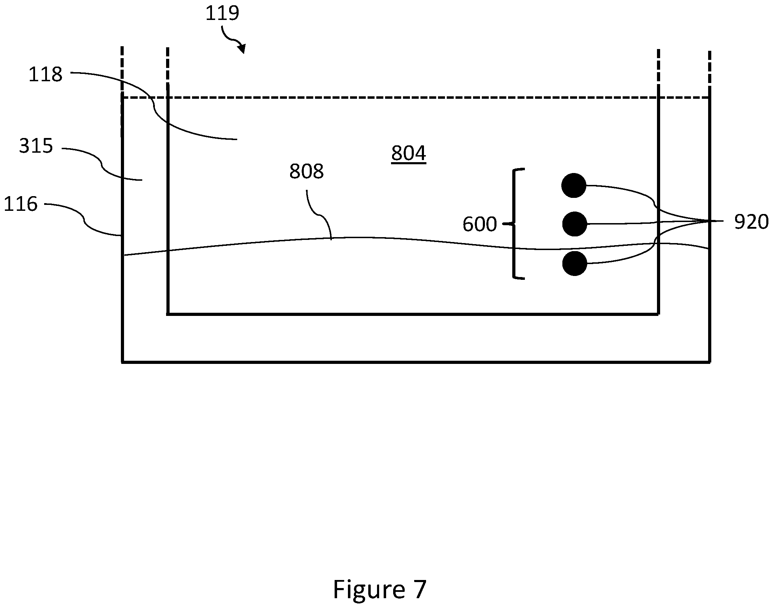

Figure 7 shows an embodiment in which a difference in pH is used to detect a leak. In this embodiment, the leak detection arrangement 600 includes one or more pH sensors 920, which are used to measure the pH of the liquid in the immediate vicinity of the pH sensors 920. It will be understood that any known electrical, electrochemical, or electronic method for measuring pH could be used by the pH sensors 920.

The dielectric immersion cooling liquid 315 and the channelized cooling liquid may have different pH values. The liquids may be selected to have this characteristic, or the pH may be measurably different simply due to chemical differences between the two liquids. In the example shown in Figure 7, a leak has occurred in the channelized cooling system, so the channelized cooling liquid 808 has collected at the bottom of the immersion case 116. The bottommost pH sensor 920 will detect that the liquid in the immediate vicinity of the pH sensor has a different pH than the dielectric immersion cooling liquid 315, indicating that a leak has occurred.

As with other embodiments, it will be understood by those of ordinary skill in the art that many variations on a system that uses pH measurements to detect the presence of the channelized cooling liquid may be used. For example, the pH sensor may be configured to be mounted in the immersion case through a "standardized" opening in the bottom portion of the immersion case, which is configured to receive any of a variety of sensors or other leak detection arrangements for determining the presence of the channelized cooling liquid in the bottom portion of the immersion case.

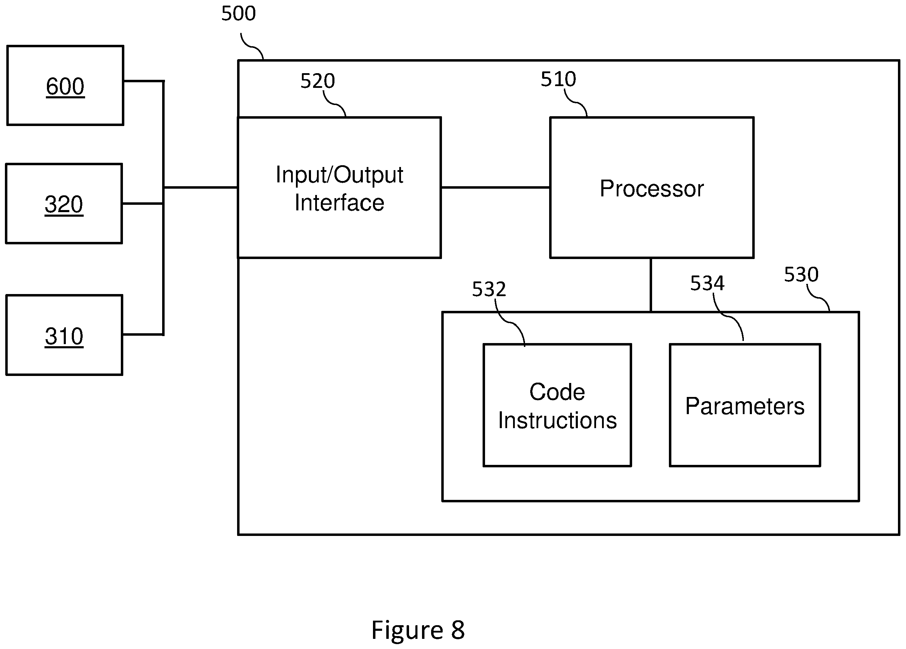

As an example, Figure 8 is a schematic block diagram of the controller 500 of the cooling monitoring system 400 according to an embodiment of the present technology. The controller 500 comprises a processor or a plurality of cooperating processors (represented as a processor 510 for simplicity), a memory device or a plurality of memory devices (represented as a memory device 530 for simplicity), and an input/output interface 520 (or separate input and output interfaces) allowing the controller 500 to communicate with other components of the cooling monitoring system 400 and/or other components in remote communication with the cooling monitoring system 400. The processor 510 is operatively connected to the memory device 530 and to the input/output interface 520. The memory device 530 includes a storage for storing parameters 534, including for example and without limitation the above-mentioned predetermined conductivity thresholds. The memory device 530 may comprise a non-transitory computer-readable medium for storing code instructions 532 that are executable by the processor 510 to allow the controller 500 to perform the various tasks allocated to the controller 500.

The controller 500 is operatively connected, via the input/output interface 520, to the leak detection arrangement 600, the switching device 310 and the temperature sensor 320. The controller 500 executes the code instructions 532 stored in the memory device 530 to implement the various above-described functions that may be present in a particular embodiment. Figure 6 as illustrated represents a non-limiting embodiment in which the controller 500 orchestrates operations of the cooling monitoring system 400. This particular embodiment is not meant to limit the present disclosure and is provided for illustration purposes.

Even though the controller 500 is depicted as a separate entity on Figure 5, the controller 500 may be part of electroinc device 120 and, more specifically, of the electronic components 122. The functions of the controller 500 described in the present disclosure may be performed by the electronic components 122 or any electronic component of the electronic device 120. In alternative embodiments, the controller 500 is remotely connected (e.g. via a networking interface) to the switching device 310, the temperature sensor 320, the leak detection arrangement 600 and/or the electronic device 120.

It is to be understood that the operations and functionality of the described cooling monitoring system 400, its constituent components, and associated processes may be achieved by any one or more of hardware-based, software-based, and firmware-based elements. Such operational alternatives do not, in any way, limit the scope of the present disclosure.

In some embodiments, the cooling monitoring system 400 are part of the electronic device 120. More specifically, the electronic device 120 may include the sensors (i.e. the leak detection arrangement 600 and the temperature sensor 320) mounted on the board 118 of the electronic device 120 and communicably connected to the electronic device 120, the functions of the controller 500 being performed by the electronic device 120.

It will be understood that, although the embodiments presented herein have been described with reference to specific features and structures, various modifications and combinations may be made without departing from the scope defined by the appended claims. For example, it is contemplated that in some embodiments, two or more of the leak detection arrangements described above may be used, in any combination. For instance, an embodiment may use a combination of a pH sensor and a conductivity sensor to detect leaks, and may also include a valve to permit manual testing and draining of leaked channelized cooling liquid. The specification and drawings are, accordingly, to be regarded simply as an illustration of the discussed implementations or embodiments and their principles as defined by the appended claims, and are contemplated to cover any and all modifications, variations, combinations or equivalents that fall within the scope defined by the appended claims.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. An electronic device (120) receiving electric power from a power supply, the electronic device (120) comprising:
a board (118) at least in part immersed in an immersion case (116) comprising a first heat-transfer liquid (315) for cooling of the electronic device (120);
the electronic device (120) being **characterized in** one or more electronic components (122) mounted onto the board (118) and cooled by one or more corresponding liquid cooling units (250) in thermal contact therewith, a second heat-transfer fluid being channelized in the one or more liquid cooling units (250) to collect thermal energy generated by the one or more electronic components (122);
the electronic device (120) further comprises
a leak detection arrangement (600) disposed in a bottom portion of the board (118) and configured to determine a presence of the second heat-transfer liquid in a bottom portion of the immersion case (116), the second heat-transfer liquid having a density that is higher than a density of the first heat-transfer liquid (315); and
a controller (500) communicably connected to the leak detection arrangement (600), the controller (500) being configured to receive signals from the leak detection arrangement (600) and, in response to determining that the signals indicate presence of the second heat-transfer liquid in the bottom portion of the immersion case (116), cause to disconnect the electronic device (120) from the power supply.

2. The electronic device (120) of claim 1, wherein:
the leak detection arrangement (600) is configured to transmit a fault signal to the controller (500) in response to detecting presence of the second heat-transfer liquid in the bottom portion of the immersion case (116); and
the controller (500) is configured to cause to disconnect the electronic device (120) from the power supply in response to receiving the fault signal.

3. The electronic device (120) of claim 1, wherein:
the leak detection arrangement (600) is configured to transmit measurement signals for the operating parameter of the first heat-transfer liquid (315) to the controller (500); and
determining, by the controller (500), that the signals indicate presence of the second heat-transfer liquid in the bottom portion of the immersion case (116) comprises comparing, by the controller (500), measurement values carried in the measurement signals with a threshold.

4. The electronic device (120) of any one of claims 1 to 3, wherein:
the second heat-transfer liquid comprises water;
the leak detection arrangement (600) comprises a conductivity sensor (605); and
the leak detection arrangement (600) is configured to indicate presence of the second heat-transfer liquid in the bottom portion of the immersion case (116) in response to detecting the conductivity being above a pre-determined conductivity threshold.

5. The electronic device (120) of claim 4, wherein:
the conductivity sensor (605) comprises a plurality of conductivity sensors (605) disposed one above another along a gravity axis; and
the controller (500) is configured to determine a fill rate of the second heat-transfer liquid within the immersion case (116) based on fault signals transmitted by two or more of the conductivity sensors (605).

6. The electronic device (120) of claim 5, wherein the controller (500) is further configured to, in response to determining the fill rate:
trigger a counter (502) indicative of an amount of time that has passed since the fill rate has been determined; and
in response to the counter (502) reaching a first pre-determined count value, cause to disconnect the electronic device from the power supply, the first pre-determined count value being based on the determined fill rate.

7. The electronic device (120) of any one of claims 1 to 3, wherein:
the second heat-transfer liquid has a pH that is different from a pH of the first heat-transfer liquid (315); and
the leak detection arrangement (600) comprises a pH sensor (920).

## Patentansprüche

1. Elektronische Vorrichtung (120), die elektrische Energie von einer Stromversorgung empfängt, wobei die elektronische Vorrichtung (120) umfasst:
eine Platine (118), die zumindest teilweise in ein Tauchgehäuse (116) eingetaucht ist, das eine erste Wärmeübertragungsflüssigkeit (315) zum Kühlen der elektronischen Vorrichtung (120) umfasst;
wobei die elektronische Vorrichtung (120) durch ein oder mehrere elektronische Komponenten (122) gekennzeichnet ist, die auf der Platine (118) montiert und durch ein oder mehrere entsprechende Flüssigkeitskühleinheiten (250) in thermischem Kontakt damit gekühlt werden, wobei ein zweites Wärmeübertragungsfluid in der einen oder den mehreren Flüssigkeitskühleinheiten (250) kanalisiert wird, um die von den elektronischen Komponenten (122) erzeugte thermische Energie zu sammeln;
wobei die elektronische Vorrichtung (120) ferner Folgendes umfasst:
eine Leckdetektionsanordnung (600), die in einem unteren Abschnitt der Platine (118) angeordnet und konfiguriert ist, um ein Vorhandensein der zweiten Wärmeübertragungsflüssigkeit in einem unteren Abschnitt des Eintauchgehäuses (116) zu bestimmen, wobei die zweite Wärmeübertragungsflüssigkeit eine Dichte aufweist, die höher als eine Dichte der ersten Wärmeübertragungsflüssigkeit (315) ist; und
eine Steuerung (500), die kommunikativ mit der Leckdetektionsanordnung (600) verbunden ist, wobei die Steuerung (500) konfiguriert ist, Signale von der Leckdetektionsanordnung (600) zu empfangen und als Reaktion auf das Bestimmen, dass die Signale das Vorhandensein der zweiten Wärmeübertragungsflüssigkeit im unteren Abschnitt des Tauchgehäuses (116) anzeigen, zu veranlassen, die elektronische Vorrichtung (120) von der Stromversorgung zu trennen.

2. Elektronische Vorrichtung (120) nach Anspruch 1, wobei:
die Leckdetektionsanordnung (600) dazu konfiguriert ist, ein Fehlersignal an die Steuerung (500) zu übertragen, als Reaktion auf das Detektieren des Vorhandenseins der zweiten Wärmeübertragungsflüssigkeit in dem unteren Abschnitt des Eintauchgehäuses (116); und
wobei die Steuerung (500) dazu konfiguriert ist, zu veranlassen, dass die elektronische Vorrichtung (120) als Reaktion auf den Empfang des Fehlersignals von der Stromversorgung getrennt wird.

3. Elektronische Vorrichtung (120) nach Anspruch 1, wobei:
die Leckdetektionsanordnung (600) konfiguriert ist, Messsignale für den Betriebsparameter der ersten Wärmeübertragungsflüssigkeit (315) an die Steuerung (500) zu übertragen; und
Bestimmen, durch die Steuerung (500), dass die Signale das Vorhandensein der zweiten Wärmeübertragungsflüssigkeit im unteren Abschnitt des Tauchgehäuses (116) anzeigen, des Vergleichens von Messwerten, die in den Messsignalen getragen werden, mit einem Schwellenwert durch die Steuerung (500) umfasst.

4. Elektronische Vorrichtung (120) nach einem der Ansprüche 1 bis 3, wobei:
die zweite Wärmeübertragungsflüssigkeit Wasser umfasst;
die Leckdetektionsanordnung (600) einen Leitfähigkeitssensor (605) umfasst; und
die Leckdetektionsanordnung (600) so konfiguriert ist, dass sie das Vorhandensein der zweiten Wärmeübertragungsflüssigkeit im unteren Abschnitt des Eintauchgehäuses (116) anzeigt, wenn die gemessene Leitfähigkeit eine vorbestimmte Leitfähigkeitsschwelle überschreitet.

5. Elektronische Vorrichtung (120) nach Anspruch 4, wobei:
der Leitfähigkeitssensor (605) eine Vielzahl von Leitfähigkeitssensoren (605) umfasst, die entlang einer Schwerkraftachse übereinander angeordnet sind; und
die Steuerung (500) dazu konfiguriert ist, die Füllrate der zweiten Wärmeübertragungsflüssigkeit innerhalb des Tauchgehäuses (116) basierend auf Fehlersignalen zu bestimmen, die von zwei oder mehr der Leitfähigkeitssensoren (605) übertragen werden.

6. Elektronische Vorrichtung (120) nach Anspruch 5, wobei die Steuerung (500) ferner konfiguriert ist, um, ansprechend auf das Bestimmen der Füllrate:
einen Zähler (502) auslösen, der anzeigt, wie viel Zeit seit dem Ermitteln der Füllrate vergangen ist; und
in Reaktion darauf, dass der Zähler (502) einen ersten vorbestimmten Zählwert erreicht, Veranlassen des Trennens der elektronischen Vorrichtung von der Stromversorgung, wobei der erste vorbestimmte Zählwert auf der bestimmten Füllrate basiert.

7. Elektronische Vorrichtung (120) nach einem der Ansprüche 1 bis 3, wobei:
die zweite Wärmeübertragungsflüssigkeit einen pH-Wert aufweist, der sich von dem pH-Wert der ersten Wärmeübertragungsflüssigkeit (315) unterscheidet; und
und die Leckdetektionsanordnung (600) einen pH-Sensor (920) umfasst.

## Revendications

1. Dispositif électronique (120) recevant une puissance électrique provenant d'une alimentation électrique, le dispositif électronique (120) comprenant :
une carte (118) immergée, au moins en partie, dans un boîtier d'immersion (116) comprenant un premier liquide caloporteur (315) pour le refroidissement du dispositif électronique (120) ;
le dispositif électronique (120) étant **caractérisé par** un ou plusieurs composants électroniques (122) montés sur la carte (118) et refroidis par une ou plusieurs unités de refroidissement liquide (250) correspondantes en contact thermique avec celle-ci, un second fluide caloporteur étant canalisé dans les une ou plusieurs unités de refroidissement liquide (250) pour collecter l'énergie thermique générée par les un ou plusieurs composants électroniques (122) ;
le dispositif électronique (120) comprend également :
un agencement de détection de fuite (600) disposé dans une partie inférieure de la carte (118) et configuré pour déterminer la présence du second liquide caloporteur dans une partie inférieure du boîtier d'immersion (116), le second liquide caloporteur ayant une densité qui est supérieure à une densité du premier liquide caloporteur (315) ; et
un dispositif de commande (500) relié en communication à l'agencement de détection de fuite (600), le dispositif de commande (500) étant configuré pour recevoir des signaux provenant de l'agencement de détection de fuite (600) et, en réponse à la détermination du fait que les signaux indiquent la présence du second liquide caloporteur dans la partie inférieure du boîtier d'immersion (116), provoquer la déconnexion du dispositif électronique (120) de l'alimentation électrique.

2. Dispositif électronique (120) selon la revendication 1, dans lequel :
l'agencement de détection de fuite (600) est configuré pour transmettre un signal de défaut au dispositif de commande (500) en réponse à la détection de la présence du second liquide caloporteur dans la partie inférieure du boîtier d'immersion (116) ; et
le dispositif de commande (500) est configuré pour provoquer la déconnexion du dispositif électronique (120) de l'alimentation électrique en réponse à la réception du signal de défaut.

3. Dispositif électronique (120) selon la revendication 1, dans lequel :
l'agencement de détection de fuite (600) est configuré pour transmettre au dispositif de commande (500) des signaux de mesure du paramètre de fonctionnement du premier liquide caloporteur (315) ; et
la détermination, par le dispositif de commande (500), du fait que les signaux indiquent la présence du second liquide caloporteur dans la partie inférieure du boîtier d'immersion (116) comprend la comparaison, par le dispositif de commande (500), de valeurs de mesure contenues dans les signaux de mesure avec un seuil.

4. Dispositif électronique (120) selon l'une quelconque des revendication 1 à 3, dans lequel :
le second liquide caloporteur comprend de l'eau ;
l'agencement de détection de fuite (600) comprend un capteur de conductivité (605) ; et
l'agencement de détection de fuite (600) est configuré pour indiquer la présence du second liquide caloporteur dans la partie inférieure du boîtier d'immersion (116) en réponse à la détection du fait que la conductivité est supérieure à un seuil de conductivité prédéterminé.

5. Dispositif électronique (120) selon la revendication 4, dans lequel :
le capteur de conductivité (605) comprend une pluralité de capteurs de conductivité (605) disposés les uns au-dessus des autres le long d'un axe de gravité ; et
le dispositif de commande (500) est configuré pour déterminer un taux de remplissage du second liquide caloporteur dans le boîtier d'immersion (116) sur la base de signaux de défaut transmis par deux des capteurs de conductivité (605) ou plus.

6. Dispositif électronique (120) selon la revendication 5, dans lequel le dispositif de commande (500) est également configuré pour, en réponse à la détermination du taux de remplissage :
déclencher un compteur (502) indiquant le temps écoulé depuis la détermination du taux de remplissage ; et
en réponse au fait que le compteur (502) atteint une première valeur de comptage prédéterminée, provoquer la déconnexion du dispositif électronique de l'alimentation électrique, la première valeur de comptage prédéterminée étant basée sur le taux de remplissage déterminé.

7. Dispositif électronique (120) selon l'une quelconque des revendications 1 à 3, dans lequel :
le second liquide caloporteur a un pH qui est différent du pH du premier liquide caloporteur (315) ; et
un agencement de détection de fuite (600) comprend un capteur de pH (920).
